# DEMANDE DE BREVET EUROPEEN

(11) **EP 4 797 247 A1**
(43) Date de publication de la demande: **26.08.2026**
(21) Numéro de dépôt: 26158898.2
(22) Date de dépôt: 16.02.2026
(51) Int. Cl.: G09F 9/33, H10H 29/24, H10H 29/30

(54) **DISPOSITIF D'AFFICHAGE D'IMAGES ET DE CONVERSION D'UNE ÉNERGIE AMBIANTE EN ÉNERGIE ÉLECTRIQUE**

(30) Priorité: 20.02.2025 FR 2501731
(71) Demandeur: Commissariat à l'Energie Atomique et aux Energies Alternatives, 75015 Paris (FR)
(72) Inventeur: BECKER, Sébastien, 38054 GRENOBLE CEDEX 09 (FR)
(74) Mandataire: Cabinet Beaumont

(57) **Abrégé**

La présente description concerne un dispositif (100) comportant : un substrat de report (101) comportant des éléments de connexion électrique (105, 109) ; une pluralité de puces élémentaires (121) fixées et connectées électriquement au substrat de report (101), chaque puce élémentaire (121) comportant au moins une LED (125) et un circuit électronique de commande (123) de ladite au moins une LED (125) ; au moins un élément (141) de conversion d'une énergie ambiante en énergie électrique fixé et connecté électriquement au substrat de report (101) ; et au moins un circuit (131) de gestion de puissance électrique fixé et connecté électriquement au substrat de report (101), le circuit (131) de gestion de puissance électrique étant configuré pour optimiser une puissance électrique délivrée par ledit au moins un élément de conversion (141) pour l'alimentation d'une charge.

## Description

### Domaine technique

La présente description concerne de façon générale le domaine des dispositifs d'affichage d'images, et vise plus particulièrement un dispositif d'affichage d'images combinant une fonction d'émission lumineuse et une fonction de conversion d'une énergie ambiante en énergie électrique. La présente description vise en outre un procédé de fabrication d'un tel dispositif.

### Technique antérieure

Des dispositifs d'affichage d'images comportant une pluralité de puces électroniques monolithiques élémentaires disposées en matrice sur un même substrat de report ont déjà été proposés, par exemple dans les demandes de brevet WO2017089676, EP3401958 et WO2018185433 précédemment déposées par le demandeur. Dans ces dispositifs, les puces élémentaires sont montées solidaires du substrat de report et connectées à des éléments de connexion électrique du substrat de report pour leur commande. Chaque puce comporte une ou plusieurs diodes électroluminescentes (LED) et un circuit de commande de ladite une ou plusieurs LED et correspond à un pixel du dispositif. Le circuit de commande comprend une face de connexion opposée à ladite une ou plusieurs LED, comprenant une pluralité de plages de connexion électrique destinées à être connectées au substrat de report pour la commande de la micropuce. Le substrat de report comprend une face de connexion comportant, pour chaque micropuce, une pluralité de plages de connexion électrique destinées à être connectées respectivement aux plages de connexion électrique de la micropuce. Les puces sont rapportées sur le substrat de report, faces de connexion tournées vers la face de connexion du substrat de report, et fixées sur le substrat de report de façon à connecter les plages de connexion électrique de chaque micropuce aux plages de connexion électrique correspondantes du substrat de report.

Ce type de dispositif d'affichage est particulièrement adapté pour réaliser des écrans d'affichage, par exemple des écrans d'ordinateur, de téléviseur, de tablette, etc.

Par ailleurs, des dispositifs d'affichage interactifs, combinant une fonction d'émission lumineuse et une fonction de capture ou d'actuation, ont été proposés, par exemple dans la demande de brevet FR3125358 précédemment déposée par le demandeur.

### Résumé de l'invention

Un mode de réalisation prévoit un dispositif comportant :
- un substrat de report comportant des éléments de connexion électrique ;
- une pluralité de puces élémentaires fixées et connectées électriquement au substrat de report, chaque puce élémentaire comportant au moins une LED et un circuit électronique de commande de ladite au moins une LED ;
- au moins un élément de conversion d'une énergie ambiante en énergie électrique fixé et connecté électriquement au substrat de report ; et
- au moins un circuit de gestion de puissance électrique fixé et connecté électriquement au substrat de report, le circuit de gestion de puissance électrique étant configuré pour optimiser une puissance électrique délivrée par ledit au moins un élément de conversion pour l'alimentation d'une charge,
dans lequel chaque circuit (131) de gestion de puissance est intégré au circuit électronique de commande (123) d'au moins l'une des puces élémentaires (401).

Selon un mode de réalisation, chaque élément de conversion d'une énergie ambiante en énergie électrique est une cellule photovoltaïque.

Selon un mode de réalisation, chaque cellule photovoltaïque comprend au moins une couche de conversion de photons en charges électriques par effet photovoltaïque, choisie parmi :
- une couche semiconductrice inorganique ;
- une couche semiconductrice organique ;
- une couche en un matériau pérovskite ; et
- une couche matrice intégrant des boîtes quantiques.

Selon un mode de réalisation, chaque élément de conversion d'une énergie ambiante en énergie électrique est adapté à convertir une énergie mécanique ou thermique en énergie électrique.

Selon un mode de réalisation, au moins l'un des éléments de conversion d'énergie exploite une source d'énergie ambiante différente de la source d'énergie ambiante exploitée par les autres éléments de conversion.

Selon un mode de réalisation, ledit au moins un élément de conversion d'une énergie ambiante en énergie électrique est relié, de préférence connecté, audit au moins un circuit de gestion de puissance.

Selon un mode de réalisation, chaque circuit de gestion de puissance est relié, de préférence connecté, au circuit électronique de commande d'au moins l'une des puces élémentaires.

Selon un mode de réalisation, chaque élément de conversion d'une énergie ambiante en énergie électrique est situé sur et en contact avec une partie du circuit électronique de commande d'au moins l'une des puces élémentaires.

Selon un mode de réalisation, chaque circuit de gestion de puissance comprend un régulateur de tension et un MPPT.

Selon un mode de réalisation, chaque circuit de gestion de puissance est réalisé en technologie CMOS.

Selon un mode de réalisation, chaque circuit de gestion de puissance comprend un élément de stockage d'énergie électrique, de préférence un condensateur, plus préférentiellement un condensateur MIM, MOM ou MIS.

Selon un mode de réalisation, la charge est constituée par au moins l'une des puces élémentaires.

Selon un mode de réalisation, la charge est constituée par une batterie.

Un mode de réalisation prévoit un procédé de fabrication d'un dispositif, le procédé comprenant les étapes successives suivantes :
a) prévoir un substrat de report comportant des éléments de connexion électrique ;
b) fixer et connecter électriquement au substrat de report une pluralité de puces élémentaires comportant chacune au moins une LED et un circuit électronique de commande de ladite au moins une LED ;
c) fixer et connecter électriquement au substrat de report au moins un circuit de gestion de puissance électrique, configuré pour optimiser une puissance électrique délivrée par au moins un élément de conversion d'une énergie ambiante en énergie électrique pour l'alimentation d'une charge ; et
d) former, sur le substrat de report, au moins un élément de conversion d'une énergie ambiante en énergie électrique, dans lequel chaque circuit (131) de gestion de puissance est intégré au circuit électronique de commande (123) d'au moins l'une des puces élémentaires (401).

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C et la figure 1D sont des vues en coupe illustrant des étapes successives d'un procédé de fabrication d'un dispositif d'affichage d'images et de conversion d'une énergie ambiante en énergie électrique selon un mode de réalisation ;
la figure 2 est une vue de dessus d'un dispositif d'affichage d'images et de conversion d'une énergie ambiante en énergie électrique selon un mode de réalisation ;
la figure 3 est une vue de dessus d'un dispositif d'affichage d'images et de conversion d'une énergie ambiante en énergie électrique selon un mode de réalisation ;
la figure 4A et la figure 4B sont des vues en coupe illustrant des étapes successives d'un procédé de fabrication d'un dispositif d'affichage d'images et de conversion d'une énergie ambiante en énergie électrique selon un mode de réalisation ; et
la figure 5 est une vue de dessus d'un dispositif d'affichage d'images et de conversion d'une énergie ambiante en énergie électrique selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses applications des dispositifs d'affichage d'images et de conversion d'une énergie ambiante en énergie électrique de la présente description n'ont pas été détaillées, les modes de réalisation décrits étant compatibles avec toutes ou la plupart des applications des dispositifs d'affichage d'images.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

Sauf précision contraire, les termes « isolant » et « conducteur » signifient respectivement électriquement isolant et électriquement conducteur.

Sauf précision contraire, l'expression « en contact avec » signifie « en contact mécanique avec ».

Selon un aspect d'un mode de réalisation, on prévoit un dispositif d'affichage d'images comportant une pluralité de puces électroniques monolithiques élémentaires disposées en matrice sur un même substrat de report. Comme dans les exemples décrits dans les demandes de brevet WO2017089676, EP3401958 et WO2018185433 précédemment déposées par le demandeur, les puces élémentaires sont montées solidaires du substrat de report et connectées à des éléments de connexion électrique du substrat de report. Chaque puce comporte une ou plusieurs LED et un circuit de commande de ladite une ou plusieurs LED et correspond à un pixel du dispositif. Le circuit de commande comprend une face de connexion opposée à ladite une ou plusieurs LED, comprenant une pluralité de plages (aussi appelées bornes ou plots) de connexion électrique destinées à être connectées au substrat de report pour la commande de la micropuce. Le substrat de report comprend une face de connexion comportant, pour chaque micropuce, une pluralité de plages (aussi appelées bornes ou plots) de connexion électrique destinées à être connectées respectivement aux plages de connexion électrique de la micropuce. Les puces sont rapportées sur le substrat de report, faces de connexion tournées vers la face de connexion du substrat de report, et fixées sur le substrat de report de façon à connecter les plages de connexion électrique de chaque micropuce aux plages de connexion électrique correspondantes du substrat de report.

Selon un aspect d'un mode de réalisation, le dispositif d'affichage d'images comprend en outre une fonction de conversion d'une énergie ambiante en énergie électrique, par exemple une fonction de conversion d'énergie lumineuse ambiante en énergie électrique par effet photoélectrique. Pour cela, le dispositif comprend au moins un élément de conversion de l'énergie ambiante en énergie électrique, par exemple au moins un élément de conversion photoélectrique. Le ou les éléments de conversion de l'énergie ambiante en énergie électrique sont disposés sur le substrat de report du dispositif, du même côté du substrat de report que les puces élémentaires de pixel. À titre de variante, le ou les éléments de conversion de l'énergie ambiante en énergie électrique peuvent être disposés sous le substrat de report du dispositif, du côté d'une face du substrat de report opposée à celle sur laquelle sont situées les puces élémentaires de pixel. Le ou les éléments de conversion de l'énergie ambiante en énergie électrique sont connectés à des bornes de connexion électrique du substrat de report pour récupération et/ou redistribution de l'énergie électrique produite par ces éléments. Le ou les éléments de conversion de l'énergie ambiante en énergie électrique sont destinés à fournir une puissance électrique à des fins d'alimentation électrique d'au moins une charge, et non pas à des fins de mesure ou de détection d'un signal.

Selon un aspect d'un mode de réalisation, le dispositif d'affichage d'images comprend en outre au moins un circuit de gestion de la puissance électrique produite par le ou les éléments de conversion de l'énergie ambiante en énergie électrique, configuré pour optimiser la puissance électrique délivrée pour l'alimentation d'une charge. À titre d'exemple, la charge peut être constituée par une ou plusieurs puces élémentaires de pixel du dispositif. À titre de variante, la charge peut être constituée par un ou plusieurs éléments de stockage d'énergie électrique, par exemple une batterie, du dispositif.

Des exemples de réalisation d'un tel dispositif d'affichage intégrant une fonction de récupération d'énergie sont décrits plus en détail ci-après en relation avec les figures.

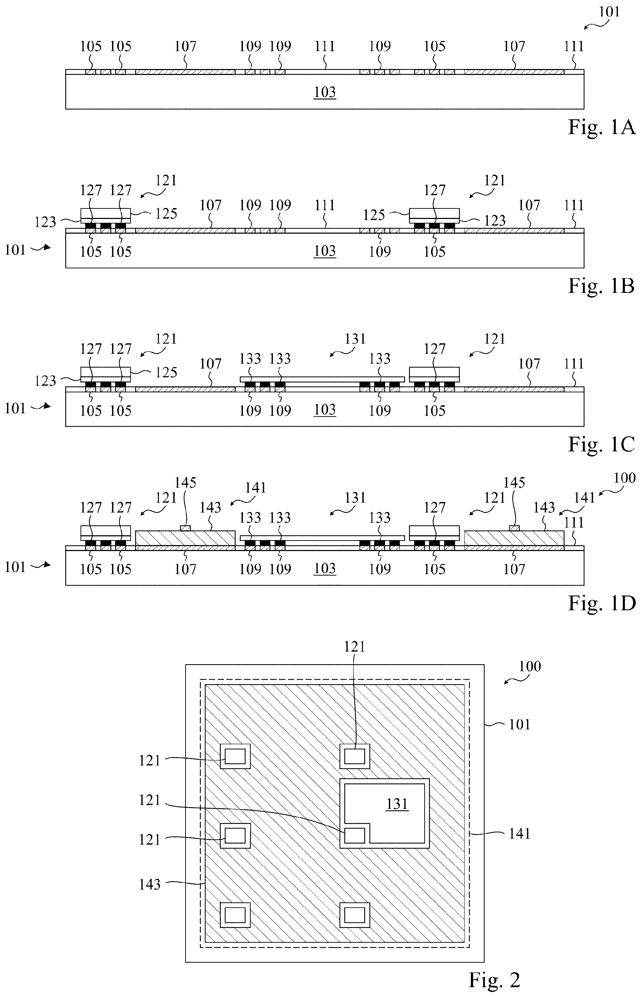

La figure 1A, la figure 1B, la figure 1C et la figure 1D sont des vues en coupe illustrant des étapes successives d'un procédé de fabrication d'un dispositif 100 d'affichage d'images et de conversion d'une énergie ambiante en énergie électrique selon un mode de réalisation.

La figure 1A illustre plus particulièrement un exemple de réalisation d'un substrat de report 101.

Le substrat de report 101 comprend par exemple une plaque ou feuille de support 103 en un matériau isolant, par exemple en verre ou en plastique. À titre de variante, la plaque ou feuille de support 103 comprend un support conducteur, par exemple métallique, recouvert par une couche d'un matériau isolant. Le substrat de report 101 comprend en outre des éléments de connexion électrique, et en particulier des pistes conductrices et des plages conductrices, formés sur la face supérieure de la plaque de support 103. Ces éléments de connexion électrique sont par exemple formés par impression d'une succession de niveaux conducteurs et isolants sur la face supérieure de la plaque de support 103. Les éléments de connexion électrique sont par exemple formés par un procédé de dépôt ou d'impression de type impression jet d'encre, par sérigraphie, par rotogravure, par dépôt sous vide, ou par toute autre méthode adaptée.

À titre d'exemple, le substrat de report 101 comprend plusieurs niveaux métalliques conducteurs, par exemple deux niveaux métalliques, séparés par un niveau isolant, et des vias métalliques connectant les deux niveaux métalliques à travers le niveau isolant. Dans l'exemple illustré, le substrat de report 101 comprend en outre des plages métalliques de connexion 105 formées sur le niveau métallique supérieur et destinées à être connectées à des plages de connexion correspondantes de puces élémentaires de pixel du dispositif 100.

Dans l'exemple illustré, le substrat de report 101 comprend en outre des électrodes 107 d'éléments de conversion d'une énergie ambiante en énergie électrique formées sur le niveau métallique supérieur. Dans l'exemple représenté, le substrat de report 101 comprend en outre des plages métalliques de connexion 109 formées sur le niveau métallique supérieur et destinées à être connectées à des plages de connexion correspondantes d'un circuit de gestion de la puissance électrique produite par le ou les éléments de conversion de l'énergie ambiante en énergie électrique, configuré pour optimiser la puissance électrique délivrée pour l'alimentation d'une charge.

Bien que cela n'ait pas été détaillé en figure 1A afin de ne pas surcharger le dessin, au moins l'une des électrodes 107 est reliée, de préférence connectée, à au moins l'une des plages métalliques de connexion 109.

Dans l'exemple représenté, la face supérieure de la plaque de support 103 est revêtue d'une alternance de régions métalliques, formées par les plages métalliques de connexion 105 et 109 et par les électrodes 107, et de régions isolantes 111, interposées latéralement entre les régions métalliques, de sorte que le substrat de report 101 présente une face supérieure sensiblement plane.

La figure 1B illustre une étape de transfert collectif de puces élémentaires de pixel 121 sur le substrat de report 101.

Les puces élémentaires 121 sont par exemple initialement fixées à une face d'un substrat de support temporaire (non représenté). La structure comportant le substrat de support temporaire et les puces élémentaires est par exemple réalisée par un procédé du type de celui décrit dans la demande de brevet FR3125358 précédemment déposée par le demandeur.

Chaque puce élémentaire 121 comporte par exemple un circuit de contrôle élémentaire 123 et une ou plusieurs LED 125, par exemple trois LED adaptées à émettre respectivement de la lumière verte, rouge et bleue.

Les puces élémentaires 121 sont rapportées collectivement en vis-à-vis de la face de connexion du substrat de report 101, à savoir sa face supérieure dans l'orientation des figures 1A à 1D, en utilisant le substrat de support temporaire comme poignée.

Des bornes de connexion 127 des puces élémentaires 121, situées du côté de la face inférieure desdites puces, sont alors mises en contact avec les plages de connexion 105 correspondantes du substrat de report 101. La fixation des bornes de connexion 127 des puces élémentaires 121 aux plages de connexion 105 du substrat de report 101 est par exemple réalisée par collage direct, par thermocompression, par brasure, au moyen de microstructures métalliques (par exemple des micro-piliers) préalablement formées sur les bornes 127, ou par toute autre méthode de fixation et de connexion adaptée.

Une fois fixées au substrat de report 101 par leurs bornes de connexion 127, les puces élémentaires 121 sont détachées du substrat de support temporaire et ce dernier est retiré, libérant l'accès à la face d'émission des LED.

Le pas des puces élémentaires 121 sur le substrat de report 101 peut être supérieur au pas des micropuces élémentaires 121 sur le substrat de support temporaire. De préférence, le pas des puces élémentaires 121 sur le substrat de report 101 est un multiple du pas des micropuces élémentaires 121 sur le substrat de support temporaire. Dans ce cas, seule une partie des puces 121 est prélevée sur le substrat de support temporaire à chaque transfert. Les autres puces 121 restent solidaires du substrat de support temporaire et peuvent être utilisées lors d'une autre étape de report collectif pour peupler une autre partie du substrat de report 101 ou un autre substrat de report.

La figure 1C illustre une étape de transfert d'un circuit de gestion de puissance 131 sur le substrat de report 101.

Le circuit de gestion de puissance 131 est par exemple initialement fixé à une face d'un substrat de support temporaire (non représenté).

Le circuit de gestion de puissance 131 comporte par exemple un régulateur de tension (« voltage regulator », en anglais) et un MPPT (de l'anglais « Maximum Power Point Tracking » - suivi du point maximal de puissance). Le circuit de gestion de puissance 131 est par exemple de type PMU (de l'anglais « Power Management Unit » - unité de gestion de puissance). Le circuit de gestion de puissance 131 est par exemple réalisé en technologie CMOS (de l'anglais « Complementary Metal-Oxide-Semiconductor » - métal-oxyde-semiconducteur complémentaire). À titre d'exemple, le circuit de gestion de puissance 131 est du type de celui décrit dans la publication de F. Galea et al. intitulée « An Ultra Low Power CMOS MPPT Power Conditioning Circuit for Energy Harvesters », 2020 IEEE International Symposium on Circuits and Systems (ISCAS).

Le circuit de gestion de puissance 131 est rapporté en vis-à-vis de la face de connexion du substrat de report 101, en utilisant le substrat de support temporaire comme poignée.

Des bornes de connexion 133 du circuit de gestion de puissance 131, situées du côté de la face inférieure du circuit, sont alors mises en contact avec les plages de connexion 109 correspondantes du substrat de report 101. La fixation des bornes de connexion 133 du circuit de gestion de puissance 131 aux plages de connexion 109 du substrat de report 101 est par exemple réalisée de manière analogue à ce qui a été décrit ci-dessus pour la fixation des bornes de connexion 127 des puces 121 aux plages de connexion 105.

Une fois fixé au substrat de report 101 par ses bornes de connexion 133, le circuit de gestion de puissance 131 est détaché du substrat de support temporaire et ce dernier est retiré.

Bien que la figure 1C illustre le report d'un seul circuit de gestion de puissance 131 sur le substrat de report 101, cet exemple n'est pas limitatif, plusieurs circuits 131 pouvant bien entendu être reportés simultanément ou successivement sur le substrat de report 101 lors de cette étape.

À l'issue de l'étape de la figure 1C, les électrodes 107 sont reliées, de préférence connectées, aux bornes de connexion 133 du ou des circuits de gestion de puissance 131.

La figure 1D illustre une étape de formation d'éléments 141 de conversion d'une énergie ambiante en énergie électrique sur le substrat de report 101.

Au cours de cette étape est par exemple déposée, pour chaque élément 141 de conversion d'une énergie ambiante en énergie électrique, une portion d'au moins une couche de conversion 143, ou couche active, sur et en contact avec la face supérieure de l'électrode 107 correspondante. La couche 143 est par exemple une couche semiconductrice de conversion de photons en charges électriques par effet photoélectrique, par exemple par effet photovoltaïque. Dans chaque élément 141 de conversion, la portion de couche 143 s'étend par exemple sur toute la face supérieure de l'électrode 107 sous-jacente. L'électrode 107 constitue par exemple une électrode inférieure de l'élément 141. À titre d'exemple, la couche de conversion 143 présente une épaisseur de l'ordre de 1 µm.

Au cours de l'étape de la figure 1D est en outre déposée, pour chaque élément 141 de conversion d'une énergie ambiante en énergie électrique, une électrode 145 supérieure située sur et en contact avec la face supérieure de la portion de couche 143.

Bien que cela n'ait pas été détaillé en figure 1D afin de ne pas surcharger le dessin, les électrodes 145 sont par exemple reliées, de préférence connectées, à au moins l'une des bornes de connexion 133 du ou des circuits de gestion de puissance 131.

À l'issue de l'étape de la figure 1D, chaque élément 141 de conversion d'énergie ambiante en énergie électrique est relié, de préférence connecté, au circuit de gestion de puissance 131 ou à l'un des circuits de gestion de puissance 131.

De manière générale, chaque élément 141 de conversion d'une énergie ambiante en énergie électrique peut être adapté à convertir une énergie quelconque, par exemple une énergie lumineuse, thermique, mécanique, etc., en énergie électrique. L'énergie électrique ainsi produite est destinée à permettre l'alimentation d'une charge interne ou externe au dispositif 100. Les éléments 141 de conversion exploitent par exemple tous la même source d'énergie ambiante. À titre de variante, au moins l'un des éléments 141 de conversion peut exploiter une source d'énergie ambiante différente de la source d'énergie ambiante exploitée par les autres éléments 141 de conversion.

En particulier, au moins l'un des éléments de conversion 141 est par exemple une cellule photovoltaïque, ou cellule solaire, destinée à convertir une énergie lumineuse ambiante, par exemple un rayonnement émis par le soleil, en énergie électrique par effet photoélectrique. Dans ce cas, la couche de conversion 143 est plus particulièrement une couche de photoconversion destinée à convertir des photons incidents en paires électron-trou. Par ailleurs, l'électrode 145 est dans ce cas transparente aux longueurs d'onde de sensibilité de la couche 143. À titre d'exemple, l'électrode 145 est en un oxyde conducteur et transparent, par exemple l'oxyde d'indium-étain (ITO).

À titre d'exemple, les éléments de conversion 141 du dispositif 100 sont à base de matériaux semiconducteurs inorganiques, par exemple à base de silicium amorphe, de polysilicium, de pérovskites, de matériaux semiconducteurs III-V, par exemple l'arséniure d'indium-gallium, de matériaux semiconducteurs II-VI, par exemple le tellurure de cadmium, etc. À titre de variante, les éléments de conversion 141 inorganiques du dispositif 100 peuvent être remplacés par des éléments de conversion à base de matériaux organiques ou comprenant une couche matrice, par exemple en résine, dans laquelle sont incorporées des boîtes quantiques (« quantum dots », en anglais).

On a décrit ci-dessus un exemple de réalisation dans lequel les éléments 141 de conversion sont des transducteurs photoélectriques. Cet exemple n'est toutefois pas limitatif. À titre de variante ou de complément, au moins l'un des éléments de conversion 141 est un transducteur thermoélectrique, électromécanique, électromagnétique, etc. La réalisation et l'intégration de ce ou ces transducteurs est à la portée de la personne du métier à partir des indications de la présente description. Par ailleurs, bien que l'on ait décrit un exemple de réalisation dans lequel les éléments 141 de conversion sont formés par dépôt sur le substrat de support 101, cet exemple n'est pas limitatif et tout ou partie des éléments 141 de conversion peuvent, à titre de variante, être réalisés sous forme de composants discrets reportés sur le substrat de support 101 de manière analogue à ce qui a été décrit ci-dessus pour le ou les circuits de gestion de puissance 131 et pour les puces élémentaires 121.

Dans un cas où la couche 143 est en un matériau organique, les portions de couche 143 sont par exemple déposées par un procédé d'impression localisée, par exemple par sérigraphie ou par un procédé de revêtement par filière à fente (« slot-die coating », en anglais).

La figure 2 est une vue de dessus du dispositif 100 d'affichage d'images et de conversion de l'énergie ambiante en énergie électrique. À des fins de lisibilité du dessin, l'électrode supérieure de l'élément 141 de conversion d'énergie ambiante en énergie électrique n'a pas été représentée en figure 2.

Dans l'exemple représenté, le dispositif 100 comporte un seul élément 141 de conversion pour un groupe de six puces élémentaires 121 voisines. Dans cet exemple, la couche de conversion 143 de l'élément 141 s'étend latéralement entre les puces élémentaires 121. Par ailleurs, dans l'exemple illustré, l'élément 141 de conversion est associé à un seul circuit 131 de gestion de puissance. Cet exemple n'est toutefois pas limitatif, le dispositif 100 pouvant plus généralement comprendre des proportions et des nombres quelconques de puces élémentaires 121, d'éléments de conversion 141 et de circuits 131 de gestion de puissance. À titre d'exemple, le dispositif 100 comprend un nombre de puces élémentaires 121 strictement supérieur au nombre d'éléments de conversion 141, de préférence un multiple entier du nombre d'éléments 141. À titre d'exemple, le dispositif 100 comprend deux, quatre, six, neuf ou seize fois plus de puces 121 que d'éléments 141. Cet exemple n'est toutefois pas limitatif, le dispositif 100 pouvant, à titre de variante, comprendre un seul élément 141 de conversion, un seul circuit 131 de gestion de puissance et plusieurs milliers ou millions de puces 121, par exemple dans le cas d'un écran de montre connectée (« smartwatch », en anglais) ou d'un écran de téléphone mobile, par exemple de smartphone. En outre, le dispositif 100 comprend par exemple un nombre de circuits 131 de gestion de puissance égal au nombre d'éléments de conversion 141. À titre de variante, le nombre de circuits 131 peut être strictement inférieur au nombre d'éléments 141, plusieurs éléments 141 étant dans ce cas reliés ou connectés à un même circuit 131.

Les éléments de conversion 141 sont par exemple dimensionnés, par exemple en termes de surface, pour produire une tension compatible avec une tension maximale admissible par le circuit 131 de gestion de puissance associé. À titre d'exemple, la tension maximale admissible est comprise dans une plage allant de 1,8 à 5 V, par exemple égale à environ 3,3 V, dans le cas où le circuit 131 est réalisé en technologie CMOS. Cet exemple n'est toutefois pas limitatif, la tension maximale admissible pouvant, à titre de variante, être supérieure à 5 V, voire supérieure à 10 V.

À titre d'exemple, le circuit 131 de gestion de puissance peut intégrer une fonction de stockage de charges électriques produites par l'élément 141 de conversion d'énergie ambiante en énergie électrique. Dans ce cas, le circuit 131 comprend par exemple un ou plusieurs éléments de stockage d'énergie électrique tels que des éléments capacitifs, par exemple des condensateurs, par exemple de type MIM (de l'anglais « Metal-Insulator-Metal » - métal-isolant-métal), MOM (de l'anglais « Metal-Oxide-Metal » - métal-oxyde-métal) ou MIS (« Metal-Insulator-Semiconductor » - métal-isolant-semiconducteur). À titre de variante, le circuit 131 de gestion de puissance peut être relié ou connecté à un élément de stockage d'énergie externe au circuit 131, par exemple une batterie ou tout autre type de circuit électrique périphérique du dispositif 100.

Bien que les figures 1D et 2 illustrent un exemple de réalisation dans lequel le circuit 131 de gestion de puissance est intégré dans la matrice émissive formée par les puces élémentaires 121 du dispositif 100, cet exemple n'est pas limitatif et le circuit 131 peut, à titre de variante, être disposé en périphérie de la matrice émissive. Dans l'exemple représenté où le circuit 131 est intégré dans la matrice émissive, le circuit 131 présente avantageusement des dimensions latérales maximales strictement inférieures au pas des puces élémentaires 121 de pixels sur le substrat de report 101. À titre d'exemple, le circuit de gestion de puissance 131 présente une dimension latérale maximale de l'ordre de 100 µm.

Le dispositif 100 a pour avantage de combiner une fonction d'affichage d'images et une fonction de conversion d'une énergie ambiante en énergie électrique. Cela permet par exemple avantageusement de réduire, voire de supprimer, les besoins en alimentation électrique externe d'un appareil électronique intégrant le dispositif 100. À titre d'exemple, ledit appareil électronique est dépourvu d'alimentation électrique externe, le ou les éléments 141 de conversion d'énergie ambiante en énergie électrique du dispositif 100 étant destinés à fournir l'intégralité de l'énergie électrique consommée par les puces élémentaires 121. Dans ce cas, au moins l'une des bornes de connexion 133 du circuit de gestion de puissance 131 est reliée, de préférence connectée, à l'une des bornes de connexion 127 d'au moins l'une des puces élémentaires 121 du dispositif 100. Cela permet par exemple au dispositif 100 de constituer un dispositif d'affichage d'images autonome en énergie, c'est-à-dire n'ayant pas besoin d'être relié à un réseau électrique.

Le fait de prévoir que le circuit 131 de gestion de puissance soit destiné à alimenter une ou plusieurs puces élémentaires 121, par exemple des puces élémentaires 121 voisines du circuit 131, présente en outre l'avantage de réduire les pertes par effet Joule.

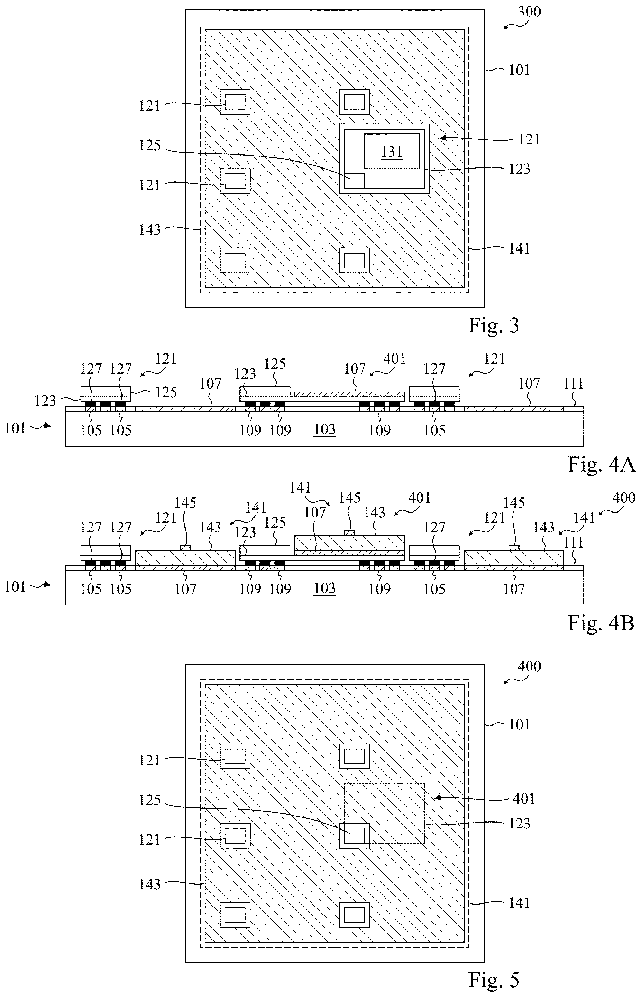

La figure 3 est une vue de dessus d'un dispositif 300 d'affichage d'images et de conversion d'une énergie ambiante en énergie électrique selon un mode de réalisation. À des fins de lisibilité du dessin, l'électrode supérieure de l'élément 141 de conversion d'énergie ambiante en énergie électrique n'a pas été représentée en figure 3.

La figure 3 illustre plus particulièrement un mode de réalisation dans lequel le circuit électronique 123 de l'une des puces élémentaires 121 comprend le circuit 131 de gestion de puissance. Dit autrement, le circuit 131 est intégré au circuit 123 de l'une des puces 121.

Un avantage du dispositif 300 est qu'il permet de tirer profit de la présence du circuit électronique 123 de l'une des puces élémentaires 121 pour intégrer le circuit de gestion de puissance 131 configuré pour optimiser une puissance électrique fournie par l'élément de conversion 141 auquel il est relié ou connecté en une puissance électrique d'alimentation d'une charge, par exemple une puissance électrique d'alimentation de la puce élémentaire 121 intégrant le circuit 131 et de cinq autres puces élémentaires 121 voisines, dans l'exemple représenté.

La figure 4A et la figure 4B sont des vues en coupe illustrant des étapes successives d'un procédé de fabrication, à partir de la structure précédemment décrite en relation avec la figure 1B, d'un dispositif 400 d'affichage d'images et de conversion d'une énergie ambiante en énergie électrique selon un mode de réalisation.

La figure 4A illustre plus particulièrement une étape de transfert d'une puce élémentaire 401 sur le substrat de report 101.

La puce élémentaire 401 diffère par exemple des puces élémentaires 121 en ce que le circuit de contrôle élémentaire 123 de la puce élémentaire 401 intègre le circuit de gestion de puissance 131 (non détaillé en figures 4A et 4B).

En outre, dans l'exemple illustré en figure 4A, une électrode 107 est formée sur la face supérieure du circuit de contrôle élémentaire 123 de la puce élémentaire 401. À titre d'exemple, l'électrode 107 de la puce 401 revêt sensiblement toute la face supérieure du circuit 123 non revêtue de la ou des LED 125.

La figure 4B illustre une étape ultérieure de formation d'éléments 141 de conversion d'une énergie ambiante en énergie électrique sur le substrat de report 101 et sur la puce 401. L'étape de la figure 4B est par exemple analogue à l'étape précédemment décrite en relation avec la figure 1D.

La figure 5 est une vue de dessus du dispositif 400 d'affichage d'images et de conversion d'énergie ambiante en énergie électrique. À des fins de lisibilité du dessin, l'électrode supérieure de l'élément 141 de conversion d'énergie ambiante en énergie électrique n'a pas été représentée en figure 5.

Dans l'exemple représenté, une partie de l'élément 141 de conversion revêt le circuit de contrôle élémentaire 123 de la puce élémentaire 401.

Le dispositif 400 présente l'avantage de permettre à l'élément de conversion 141 d'occuper une surface supérieure par rapport aux dispositifs 200 et 300. À quantité d'énergie ambiante égale, le dispositif 400 est ainsi capable de fournir une quantité d'énergie électrique supérieure à celle fournie par les dispositifs 100 et 300.

Bien que cela n'ait pas été représenté, l'élément de conversion 141 peut, dans le cas d'un élément de conversion photovoltaïque, être coplanaire avec les éléments émissifs 125 des puces élémentaires. À titre de variante, l'élément de conversion 141 peut être disposé devant les éléments émissifs 125, par exemple dans un cas où l'élément 141 forme une cellule solaire transparente dans la gamme d'émission des puces élémentaires d'affichage d'images. À titre de variante, l'élément de conversion 141 peut être disposé sous les éléments émissifs 125, par exemple en prévoyant des connexions prévues sur la face avant de l'élément de conversion 141 pour le contrôle des LED 125, voire en face arrière du substrat de report 101, par exemple en prévoyant des éléments de connexion électrique, par exemple des vias conducteurs, entre les faces avant et arrière du substrat 101.

Par ailleurs, bien que cela n'ait pas été illustré sur les figures, au moins l'une des puces élémentaires de pixel peut être utilisée pour commander un ou plusieurs autres éléments externes à la puce élémentaire, par exemple choisis parmi un photodétecteur, un transducteur ultrasonore ou acoustique, un VCSEL (de l'anglais « Vertical-Cavity surface-emitting laser » - diode laser à cavité verticale émettant par la surface). Ceci permet par exemple de mettre en œuvre des fonctions de détection de toucher ou de proximité d'un objet, par exemple la main d'un utilisateur, par exemple en utilisant l'effet piézoélectrique direct, et/ou des fonctions de stimulation haptique, et/ou des fonctions d'émission d'ondes acoustiques directives, par exemple en utilisant l'effet piézoélectrique indirect.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples particuliers de réalisation des puces élémentaires de pixel et du substrat de report 101 décrits en relation avec les figures 1A à 1D, 2, 3, 4A, 4B et 5.

Enfin, la mise en œuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

## Revendications

1. Dispositif (100 ; 300 ; 400) comportant :
- un substrat de report (101) comportant des éléments de connexion électrique (105, 109) ;
- une pluralité de puces élémentaires (121 ; 401) fixées et connectées électriquement au substrat de report (101), chaque puce élémentaire (121 ; 401) comportant au moins une LED (125) et un circuit électronique de commande (123) de ladite au moins une LED (125) ;
- au moins un élément (141) de conversion d'une énergie ambiante en énergie électrique fixé et connecté électriquement au substrat de report (101) ; et
- au moins un circuit (131) de gestion de puissance électrique fixé et connecté électriquement au substrat de report (101), le circuit (131) de gestion de puissance électrique étant configuré pour optimiser une puissance électrique délivrée par ledit au moins un élément de conversion (141) pour l'alimentation d'une charge,
dans lequel chaque circuit (131) de gestion de puissance est intégré au circuit électronique de commande (123) d'au moins l'une des puces élémentaires (401).

2. Dispositif (100 ; 300 ; 400) selon la revendication 1, dans lequel chaque élément (141) de conversion d'une énergie ambiante en énergie électrique est une cellule photovoltaïque.

3. Dispositif (100 ; 300 ; 400) selon la revendication 2, dans lequel chaque cellule photovoltaïque comprend au moins une couche (143) de conversion de photons en charges électriques par effet photovoltaïque, choisie parmi :
- une couche semiconductrice inorganique ;
- une couche semiconductrice organique ;
- une couche en un matériau pérovskite ; et
- une couche matrice intégrant des boîtes quantiques.

4. Dispositif (100 ; 300 ; 400) selon la revendication 1, dans lequel chaque élément (141) de conversion d'une énergie ambiante en énergie électrique est adapté à convertir une énergie mécanique ou thermique en énergie électrique.

5. Dispositif selon l'une quelconque des revendications 1 à 4, dans lequel au moins l'un des éléments (141) de conversion d'énergie exploite une source d'énergie ambiante différente de la source d'énergie ambiante exploitée par les autres éléments (141) de conversion.

6. Dispositif (100 ; 300 ; 400) selon l'une quelconque des revendications 1 à 5, dans lequel ledit au moins un élément (141) de conversion d'une énergie ambiante en énergie électrique est relié, de préférence connecté, audit au moins un circuit (131) de gestion de puissance.

7. Dispositif (100) selon l'une quelconque des revendications 1 à 6, dans lequel chaque circuit (131) de gestion de puissance est relié, de préférence connecté, au circuit électronique de commande (123) d'au moins l'une des puces élémentaires (121).

8. Dispositif (100 ; 300 ; 400) selon l'une quelconque des revendications 1 à 7, dans lequel chaque élément (141) de conversion d'une énergie ambiante en énergie électrique est situé sur et en contact avec une partie du circuit électronique de commande (123) d'au moins l'une des puces élémentaires (121 ; 401).

9. Dispositif (100 ; 300 ; 400) selon l'une quelconque des revendications 1 à 8, dans lequel chaque circuit (131) de gestion de puissance comprend un régulateur de tension et un MPPT.

10. Dispositif (100 ; 300 ; 400) selon l'une quelconque des revendications 1 à 9, dans lequel chaque circuit (131) de gestion de puissance est réalisé en technologie CMOS.

11. Dispositif (100 ; 300 ; 400) selon l'une quelconque des revendications 1 à 10, dans lequel chaque circuit (131) de gestion de puissance comprend un élément de stockage d'énergie électrique, de préférence un condensateur, plus préférentiellement un condensateur MIM, MOM ou MIS.

12. Dispositif (100 ; 300 ; 400) selon l'une quelconque des revendications 1 à 11, dans lequel la charge est constituée par au moins l'une des puces élémentaires (121 ; 401).

13. Dispositif (100 ; 300 ; 400) selon l'une quelconque des revendications 1 à 11, dans lequel la charge est constituée par une batterie.

14. Procédé de fabrication d'un dispositif (100 ; 300 ; 400), le procédé comprenant les étapes successives suivantes :
a) prévoir un substrat de report (101) comportant des éléments de connexion électrique (105 ; 109) ;
b) fixer et connecter électriquement au substrat de report (101) une pluralité de puces élémentaires (121 ; 401) comportant chacune au moins une LED (125) et un circuit électronique de commande (123) de ladite au moins une LED (125) ;
c) fixer et connecter électriquement au substrat de report (101) au moins un circuit (131) de gestion de puissance électrique, configuré pour optimiser une puissance électrique délivrée par au moins un élément (141) de conversion d'une énergie ambiante en énergie électrique pour l'alimentation d'une charge ; et
d) former, sur le substrat de report (101), au moins un élément (141) de conversion d'une énergie ambiante en énergie électrique,
dans lequel chaque circuit (131) de gestion de puissance est intégré au circuit électronique de commande (123) d'au moins l'une des puces élémentaires (401).
